# EUROPEAN PATENT SPECIFICATION

(11) **EP 3 881 299 B1**
(45) Date of publication and mention of the grant of the patent: **17.06.2026**
(21) Application number: 19804680.7
(22) Date of filing: 12.11.2019
(51) Int. Cl.: G08B 13/08, G08B 29/04

(54) **ALARM SYSTEM DETECTOR FOR DOOR OR WINDOW**
ALARMERFASSUNGSSYSTEM FÜR TÜR ODER FENSTER
DÉTECTEUR DE SYSTÈME D'ALARME POUR PORTE OU FENÊTRE

(30) Priority: 13.11.2018 SE 1851414
(43) Date of publication of application: 22.09.2021
(73) Proprietor: Verisure Sàrl, 1290 Versoix (CH)
(72) Inventor: MÅRTENSSON, Henrik, 226 52 Lund (SE); AKHLAGI, Noroz, 247 94 Dalby (SE)
(74) Representative: Hansson Thyresson AB
(86) International application number: PCT/EP2019/080959
(87) International publication number: WO 2020/099371

(56) References cited:
- WO-A1-2018/055398
- US-A1- 2017 098 356
- US-A1- 2017 131 356
- US-A1- 2017 227 386
- US-B2- 9 569 943

## Description

### TECHNICAL FIELD

The invention relates to an alarm system detector for use with a door or window.

### PRIOR ART

The document WO 2018/055398 A1 discloses a system for detecting the position of a moveable element of a window or door assembly. The system comprises a sensor for sensing a magnetic field, the sensor being configured such that the magnetic field sensed changes as the moveable element moves. The system comprises a processor configured to receive output signals associated with the sensed magnetic field. The system can operate in a calibration mode and a normal mode.

The document US 2017/131356 A1 discloses an alarm system detector for use with a door or window. ¶

The alarm system detector comprises a sensing system. The document US 2017/227386 A1 also discloses an alarm system detector for use with a door or window. The alarm system detector comprises a magnetometer.

### SUMMARY OF THE INVENTION

The present application discloses an alarm system detector for an alarm system in accordance with the independent system claim.

According to a first aspect, there is provided an alarm system detector according to claim 1.

Additional advantages will be set forth in part in the description which follows or may be learned by practice. The advantages will be realized and attained by means of the elements and combinations particularly pointed out in the appended claims.

### BRIEF DESCRIPTION OF THE DRAWINGS

The accompanying drawings, which are incorporated in and constitute a part of this specification, illustrate embodiments and together with the description, serve to explain the principles of the systems and methods. In the drawings,
- Fig. 1: is a schematic view of an installation of a home wireless system controlled in accordance with one embodiment of the invention
- Fig. 2: is a front view of a window with two moveable window frames and a non-moveable frame, provided with a detector main unit and one permanent magnet per moveable frame.
- Fig. 3: is detailed view of the window with detector of Fig. 1.
- Fig. 4: is a flowchart of a detection method
- Fig. 5: is a flowchart of an installation method
- Fig. 6: is a flowchart of another installation method

### DETAILED DESCRIPTION

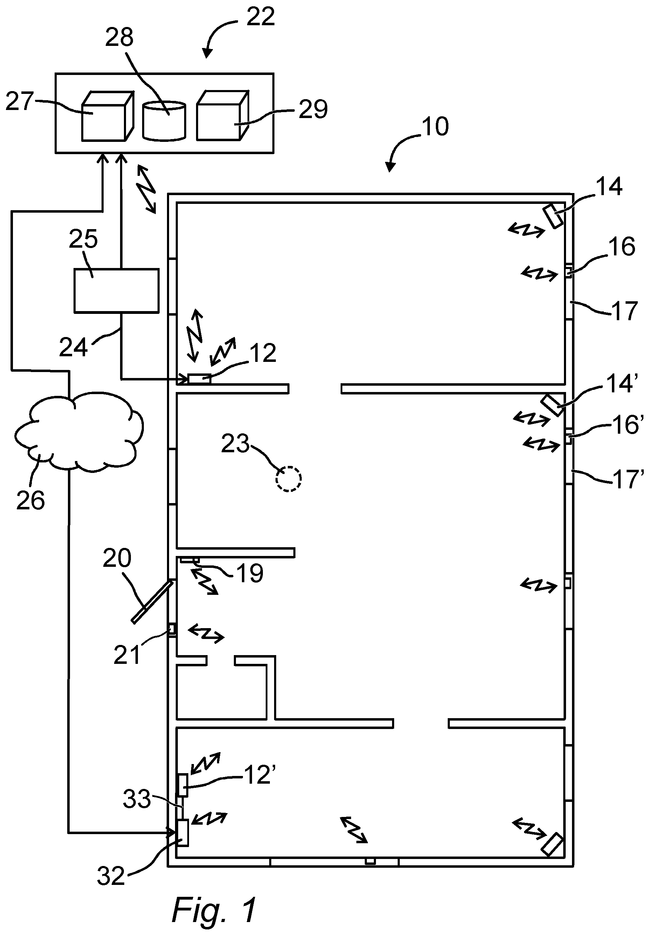

In the embodiment shown in Fig. 1 an installation comprising a home wireless system is installed in a building 10. The home wireless system is an alarm system installation and comprises a plurality of wireless peripheral nodes including wireless peripheral devices, a first gateway 12 and a second gateway 12'. The second gateway 12' is mains powered and normally is not provided with battery backup. One wireless peripheral node is a first infrared detector 14 mounted in the corner of a room close to the ceiling. The first infrared detector 14 has a sensing area that covers the first gateway 12. A first perimeter alarm detector 16 is mounted at a window 17 in the same room. The infrared detector operates in a conventional manner to detect presence and movements of objects emitting infrared radiation. The perimeter alarm detector also operates in a conventional manner to detect when a door or a window is opened. In various embodiments the perimeter alarm detector comprises a magnetic sensor that will detect when a magnet attached to the door or window is moved.

Second gateway 12' is arranged in a second room separated from the room where the first gateway 12 is arranged. A second infrared detector 14' is mounted in the same room as the second gateway 12' to cover it within its operative area and a second perimeter alarm detector 16' is mounted at a window 17' in the same room. A keypad 19 is mounted close to a front door 20 of the building 10. The keypad 19 is used by an operator of the alarm system to arm and to disarm the alarm system. The keypad 19 also is a wireless peripheral node. The front door 20 is covered by a third perimeter alarm detector 21. Another type of wireless peripheral device is a smoke detector 23 mounted in the ceiling of building. In various embodiments a plurality of smoke detectors 23 are arranged throughout the building 10 to ensure that fire can be detected at an early stage.

Depending on different circumstances the first gateway 12 and the second gateway 12' are connected to a remote central monitoring station 22 either through a wired connection 24 or through a wireless connection such as GSM or a similar digital cellular network. The connection to the remote central monitoring station 22 can also be through the internet 26. In the embodiment shown in Fig. 1, internet connection is provided through a wireless router 32 that is connected to internet by fibre, cable or Digital Subscriber Line, such as ADSL. In the embodiment shown in Fig. 1 second gateway 12' is connected by wire 33 to wireless router 32. The wired connection 24 can be part of a public switched telephone network 25. In various embodiments the remote central monitoring station 22 comprises an interface module 27, a database 28 and a web server 29. The database 28 stores installation and application data relating to the installation including all wireless network nodes and alarm settings.

The first gateway 12 can be capable of communicating with the second gateway 12' because of the more powerful radio transmitting means. By placing gateways strategically within a building, it is possible to guarantee that every peripheral node has an adequate RF link with at least one gateway. As long as the gateways can all communicate with each other, the installation will function properly. To achieve full redundancy the installation should include enough gateways for every peripheral node to be able to communicate with at least two gateways.

An installation such as the alarm system shown in Fig. 1 holds a large amount of dynamic state information, such as arm state, alarm status, peripheral battery status, etc. in a total system state information dataset. Similar information is stored also in other types of home wireless systems. Each gateway or controller continuously receives inputs from different authenticated sources such as peripheral nodes, a RCMS, adjacent systems, etc. that affects a distributed state of the application or system.

In various embodiments, a second gateway can utilize the RF communication link of another gateway for tunneling messages to a remote central monitoring station (RCMS). For example, if the second gateway up-link to RCMS is very slow or unreachable, or has a higher cost, another gateway up-link can be utilized.

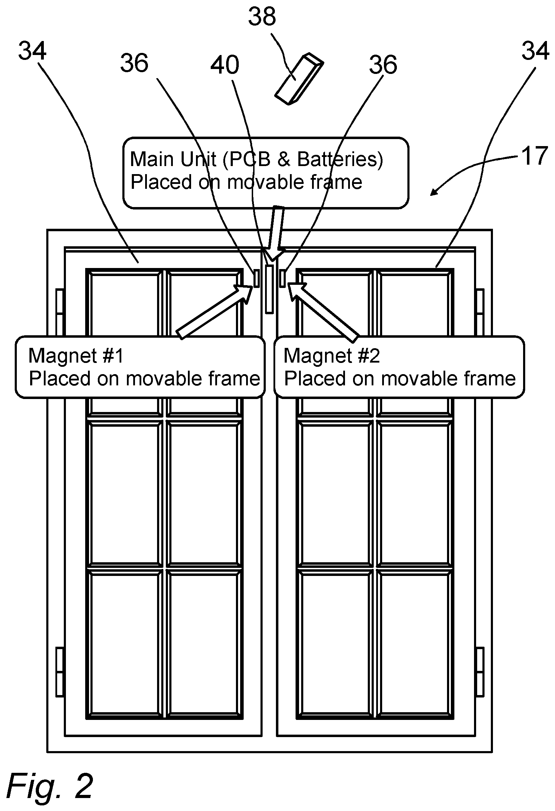

The detector of the present invention detects changes in magnetic field by use of a magnetometer. Magnetometers are generally available and can be acquired from e.g. Asahi KASEI - AK09970 or equivalent. This enables new features for traditional magnetic contact products:
Enable open/close functionality of two moving window sections 34 by use of two magnets 36 and one main unit/sensor housing is shown in Fig. 2.

Protection against external manipulation by using a strong magnet 38. Enabled by measuring deviation in magnetic strength and magnetic field direction. Once manipulation is detected then an alarm signal will be sent (function part of "shield protection").

Field of magnet detection (x, y, z) is adjusted (software parameters) at installation to better fit the unique installation which decreases the need of magnet spacers.

Field of magnet detection (x, y, z) can be adjusted by arranging the door/window in desired position and then this setting is recorded into the system (as an option to use instead of #3).

Since field of magnetic detection is adjustable this could enable a solution were a possible smaller and/or cheaper magnet is used.

Possible to identify the magnet(s) used and thus to detect tampering attempts.

Possible to market shell (perimeter) protection because of use of one main unit covering two windows (lower customer costs)

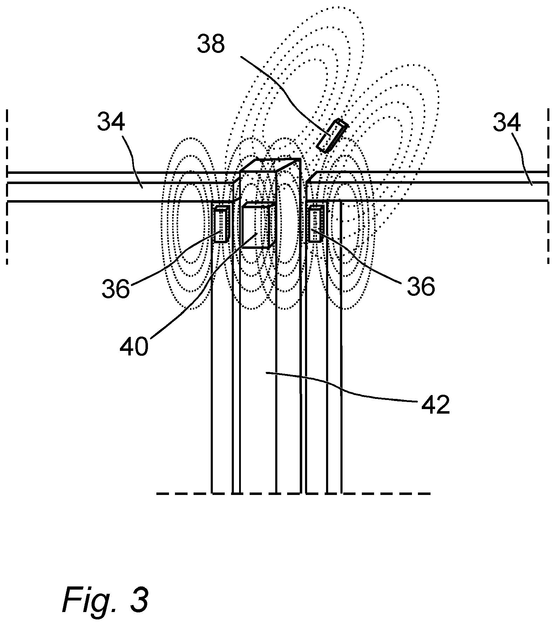

Thus, there is provided an alarm system detector for use with a door or window 34, the detector comprising a magnetometer 40 for measuring strength and direction of a magnetic field, and a processor (not shown) connected to the magnetometer, wherein the magnetometer 40 is configured to sense the magnetic field (drawn as field lines in Fig. 3) in the vicinity of the magnetometer. The processor is further configured to analyze the strength and direction of the magnetic field. The magnetometer and the processor may be housed in a magnetometer housing 40
Further, the processor is configured to compare the strength of the magnetic field in two directions with two thresholds for each direction and send a signal to a displaced control unit, indicative of the result of the comparisons.

The detector advantageously further comprises one or more permanent magnets 36 configured to be mountable on a moveable portion of one or more door or windows 34.

The detector, wherein the processor is advantageously connected to a wireless unit for communicating status information to a displaced control unit

The processor is configured to analyze change in the magnetic field and direction.
The processor may be configured to detect one or more of the following: a door/window being in an open position, a door/window being in a closed position. The processor may be configured to detect one or more of the following: opening of a door/window, closing of a door/window;
The detector, wherein the processor is configured to detect opening of a sliding door/window, closing of a sliding door/window, opening of a swinging door/window, closing of a swinging door/window;
The magnetometer may be configured to be mounted between two doors/windows, and the processor is configured to detect which one of the doors/windows that are in an opened or closed position.

The processor **is** configured to detect a magnetic field change corresponding to an attempt to tamper with the detector by applying an external magnetic field. This may be the case if a burglar uses a strong handheld magnet to try to fool the system.

The processor may be configured to compare the magnetic field to a third, higher threshold for determining a tamper attempt.

processor and/or the magnetometer are configured to sample the magnetic field at a first sample frequency, and upon detecting an increasing magnetic field shift to a second, higher sample frequency, thereby increasing the possibility to detect a tampering attempt.

The detector, wherein the processor is configured to detect a tampering attempt by identifying an increasing magnetic field over time.

Main unit (magnet sensor) can detect any of the following cases by measuring magnetic strength(T):
T₀ = no magnet is present => both windows are open
T₁ = one magnet is present => one of the windows are open
T₂ = two magnets are present => both windows are closed

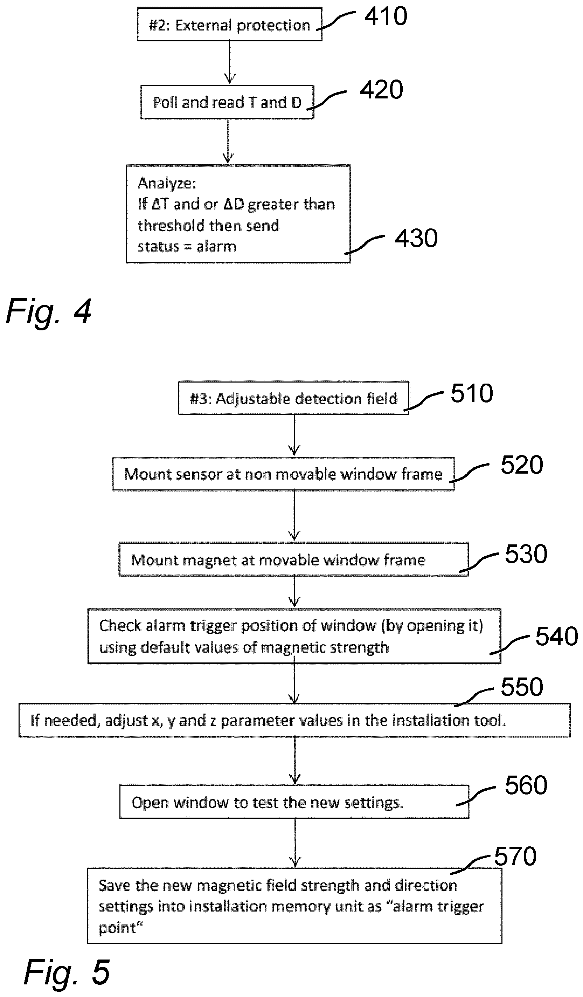

In an external protection example of Fig. 4 processor polls and reads 420 magnetic field strength (T) and magnetic field direction (D). Processor may be configured to analyze 430 such that if change ΔT of magnetic field strength over predetermined time and/or magnetic field direction ΔD is greater than predetermined threshold then processor sends an alarm signal.

Fig. 5 discloses an installation method for achieving an adjustable detection field. The method comprises the following steps:
- Mounting 520 sensor at non-moveable window frame;
- Mounting 530 magnet at movable window frame 34;
- Checking 540 alarm trigger position of window (by opening it) using default values of magnetic strength
- If needed, adjusting 550 x, y and z parameter values in an installation tool;
- Opening 560 window to test the new settings
- Saving 570 the new magnetic field strength and direction settings into an installation memory unit as "alarm trigger point"

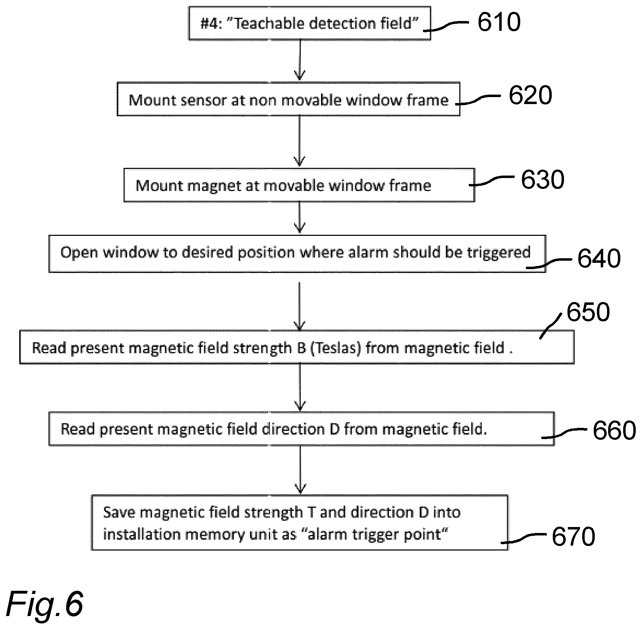

Fig. 6 discloses an installation method which is not part of the present invention, for teaching detection field called "Teachable detection field". The method may comprise the following steps:
- Mounting 620 sensor at non movable window frame;
- Mounting 630 magnet at movable window frame;
- Opening 640 window to desired position where alarm should be triggered;
- Reading 650 present magnetic field strength B (Tesla) from magnetic field;
- Reading 660 present magnetic field direction D from magnetic field;
- Save 670 magnetic field strength T and direction D into installation memory unit as "alarm trigger point";

It will be apparent to those skilled in the art that various modifications and variations can be made without departing from the inventive concept as defined in the appended claims.
Other embodiments will be apparent to those skilled in the art from consideration of the specification and practice disclosed herein. It is intended that the specification and examples be considered as exemplary only.

## Claims

1. An alarm system detector for use with a door or window (34), the detector comprising
- a magnetometer (40) for measuring strength and direction of a magnetic field;
- a processor (40) connected to the magnetometer (40);
wherein the magnetometer (40) is configured to sense the magnetic field in the vicinity of the magnetometer (40), wherein
- the processor (40) is configured to analyze the strength and the direction of the magnetic field;
- the processor (40) is configured to compare the strength of the magnetic field in two directions with two thresholds for each direction and send a signal to a displaced control unit, indicative of the result of the comparisons,
**characterized in that** the processor (40) and/or the magnetometer (40) is configured to sample the magnetic field at a first sample frequency, and upon detecting an increasing magnetic field shift to a second, higher sample frequency, thereby increasing the possibility to detect a tampering attempt.

2. The detector according to claim 1, further comprising one or more permanent magnets (36) configured to be mountable on a moveable portion (34) of one or more door or windows.

3. The detector according to claim 1 or 2, wherein the processor is connected to a wireless unit for communicating status information to a displaced control unit.

4. The detector according to claim 1, 2 or 3, wherein the processor is configured to analyze change in the magnetic field and direction.

5. The detector according to claim 4, wherein the processor is configured to detect one or more of the following:
- a door/window being in an open position;
- a door/window being in a closed position.

6. The detector according to claim 4 or 5, wherein the processor is configured to detect one or more of the following:
- opening of a door/window;
- closing of a door/window.

7. The detector according to claim 4 or 5 or 6, wherein the processor is configured to detect one or more of the following:
- opening of a sliding door/window;
- closing of a sliding door/window;
- opening of a swinging door/window;
- closing of a swinging door/window.

8. The detector according to any of the claims 1-5 wherein the magnetometer is configured to be mounted between two doors/windows, and the processor is configured to detect which one of the doors/windows is in an opened or closed position.

9. The detector according to any of the claims 1-5 wherein the processor is configured to detect a magnetic field change corresponding to an attempt to tamper with the detector by applying an external magnetic field.

10. The detector according to claim 9 wherein the processor is configured to compare the magnetic field to a third, higher threshold for determining a tamper attempt.

11. The detector according to claim 1 wherein the processor is configured to detect a tampering attempt by identifying an increasing magnetic field over time.

## Patentansprüche

1. Alarmsystem-Detektor zur Verwendung mit einer Tür oder einem Fenster (34), wobei der Detektor umfasst:
- ein Magnetometer (40) zum Messen von Stärke und Richtung eines Magnetfelds;
- einen Prozessor (40), der mit dem Magnetometer (40) verbunden ist;
wobei das Magnetometer (40) konfiguriert ist, um das Magnetfeld im Umfeld des Magnetometers (40) wahrzunehmen, wobei
- der Prozessor (40) konfiguriert ist, um die Stärke und die Richtung des Magnetfelds zu analysieren;
- der Prozessor (40) konfiguriert ist, um die Stärke des Magnetfelds in zwei Richtungen mit zwei Schwellenwerten für jede Richtung zu vergleichen und ein Signal an eine verlagerte Steuereinheit zu senden, das auf das Ergebnis der Vergleiche hinweist,
**dadurch gekennzeichnet, dass** der Prozessor (40) und/oder das Magnetometer (40) konfiguriert ist, um das Magnetfeld bei einer ersten Abtastfrequenz abzutasten, und beim Erkennen einer sich erhöhenden Magnetfeldverschiebung zu einer zweiten, höheren Abtastfrequenz wechselt, wodurch die Möglichkeit erhöht wird, einen Manipulationsversuch zu erkennen.

2. Detektor nach Anspruch 1, ferner umfassend einen oder mehrere Permanentmagnete (36), die konfiguriert sind, um an einem beweglichen Teil (34) einer oder mehrerer Türen oder Fenster angebracht zu werden.

3. Detektor nach Anspruch 1 oder 2, wobei der Prozessor mit einer drahtlosen Einheit zum Kommunizieren von Statusinformationen an eine verlagerte Steuereinheit verbunden ist.

4. Detektor nach Anspruch 1, 2 oder 3, wobei der Prozessor konfiguriert ist, um Änderungen in dem Magnetfeld und der Richtung zu analysieren.

5. Detektor nach Anspruch 4, wobei der Prozessor konfiguriert ist, um ein oder mehreres von Folgendem zu erkennen:
- eine Tür/ein Fenster, die/das in einer offenen Position ist;
- eine Tür/ein Fenster, die/das in einer geschlossenen Position ist.

6. Detektor nach Anspruch 4 oder 5, wobei der Prozessor konfiguriert ist, um ein oder mehreres von Folgendem zu erkennen:
- Öffnen einer Tür/eines Fensters;
- Schließen einer Tür/eines Fensters.

7. Detektor nach Anspruch 4 oder 5 oder 6, wobei der Prozessor konfiguriert ist, um ein oder mehreres von Folgendem zu erkennen:
- Öffnen einer Schiebetür/eines Schiebefensters;
- Schließen einer Schiebetür/eines Schiebefensters;
- Öffnen einer Schwingtür/eines Schwingfensters;
- Schließen einer Schwingtür/eines Schwingfensters.

8. Detektor nach einem der Ansprüche 1 bis 5, wobei das Magnetometer konfiguriert ist, um zwischen zwei Türen/Fenstern angebracht zu werden, und der Prozessor konfiguriert ist, um zu erkennen, welche der Türen/Fenster in einer geöffneten oder geschlossenen Position ist.

9. Detektor nach einem der Ansprüche 1 bis 5, wobei der Prozessor konfiguriert ist, um eine Magnetfeldänderung zu erkennen, die einem Manipulationsversuch am Detektor durch Anlegen eines externen Magnetfelds entspricht.

10. Detektor nach Anspruch 9, wobei der Prozessor konfiguriert ist, um das Magnetfeld mit einem dritten, höheren Schwellenwert zum Bestimmen eines Manipulationsversuchs zu vergleichen.

11. Detektor nach Anspruch 1, wobei der Prozessor konfiguriert ist, um einen Manipulationsversuch durch Identifizieren eines sich mit der Zeit erhöhenden Magnetfelds zu erkennen.

## Revendications

1. Détecteur de système d'alarme destiné à être utilisé avec une porte ou fenêtre (34), le détecteur comprenant
- un magnétomètre (40) pour mesurer l'intensité et la direction d'un champ magnétique ;
- un processeur (40) connecté au magnétomètre (40) ;
dans lequel le magnétomètre (40) est configuré pour détecter le champ magnétique au voisinage du magnétomètre (40), dans lequel
- le processeur (40) est configuré pour analyser l'intensité et/ou la direction du champ magnétique ;
- le processeur (40) est configuré pour comparer l'intensité du champ magnétique dans deux directions avec deux seuils pour chaque direction et envoyer un signal à une unité de commande déplacée, indicatif du résultat des comparaisons, **caractérisé en ce que**
le processeur (40) et/ou le magnétomètre (40) est configuré pour échantillonner le champ magnétique à une première fréquence d'échantillonnage, et lors de la détection d'un champ magnétique croissant, passer à une deuxième fréquence d'échantillonnage plus élevée, augmentant ainsi la possibilité de détecter une tentative d'effraction.

2. Détecteur selon la revendication 1, comprenant en outre un ou plusieurs aimants permanents (36) configurés pour être montés sur une partie mobile (34) d'une ou plusieurs portes ou fenêtres.

3. Détecteur selon la revendication 1 ou 2, dans lequel le processeur est connecté à une unité sans fil pour communiquer des informations d'état à une unité de commande déplacée.

4. Détecteur selon la revendication 1, 2 ou 3, dans lequel le processeur est configuré pour analyser le changement du champ magnétique et de sa direction.

5. Détecteur selon la revendication 4, dans lequel le processeur est configuré pour détecter une ou plusieurs des suivantes :
- une porte/fenêtre étant dans une position ouverte ;
- une porte/fenêtre étant dans une position fermée.

6. Détecteur selon la revendication 4 ou 5, dans lequel le processeur est configuré pour détecter une ou plusieurs des suivantes :
- l'ouverture d'une porte/fenêtre ;
- la fermeture d'une porte/fenêtre.

7. Détecteur selon la revendication 4 ou 5 ou 6, dans lequel le processeur est configuré pour détecter une ou plusieurs des suivantes :
- l'ouverture d'une porte/fenêtre coulissante ;
- la fermeture d'une porte/fenêtre coulissante ;
- l'ouverture d'une porte/fenêtre battante ;
- la fermeture d'une porte/fenêtre battante.

8. Détecteur selon l'une quelconque des revendications 1 à 5, dans lequel le magnétomètre est configuré pour être monté entre deux portes/fenêtres, et le processeur est configuré pour détecter laquelle des portes/fenêtres est dans une position ouverte ou fermée.

9. Détecteur selon l'une quelconque des revendications 1 à 5, dans lequel le processeur est configuré pour détecter un changement de champ magnétique correspondant à une tentative d'effraction avec le détecteur par application d'un champ magnétique externe.

10. Détecteur selon la revendication 9, dans lequel le processeur est configuré pour comparer le champ magnétique à un troisième seuil plus élevé pour déterminer une tentative d'effraction.

11. Détecteur selon la revendication 1, dans lequel le processeur est configuré pour détecter une tentative d'effraction en identifiant un champ magnétique croissant au fil du temps.
